Europäisches Patentamt

European Patent Office

Office européen des brevets

(11) Veröffentlichungsnummer: **0 253 283**
**A2**

# (12) EUROPÄISCHE PATENTANMELDUNG

(21) Anmeldenummer: 87109818.2

(22) Anmeldetag: 07.07.87

(51) Int. Cl.⁴: **G03F 7/20 , G03F 9/00**

(30) Priorität: 15.07.86 DE 3623875

(43) Veröffentlichungstag der Anmeldung:
20.01.88 Patentblatt 88/03

(84) Benannte Vertragsstaaten:
DE FR GB NL

(71) Anmelder: **Siemens Aktiengesellschaft Berlin und München**
**Wittelsbacherplatz 2**
**D-8000 München 2(DE)**

Anmelder: **Karl Süss KG Präzisionsgeräte für Wissenschaft und Industrie - GmbH & Co.**
**Schleissheimer Strasse 90 Postfach 1809**
**D-8046 Garching bei München(DE)**

Anmelder: **FRAUNHOFER-GESELLSCHAFT ZUR FÖRDERUNG DER ANGEWANDTEN FORSCHUNG E.V. -**
**Leonrodstrasse 54**
**D-8000 München 19(DE)**

(72) Erfinder: **Müller, Karl-Heinz, Dr.**
**Holtheimer Weg 9**
**D-1000 Berlin 45(DE)**
Erfinder: **Betz, Hans, Dr.-Ing.**
**Ludwigkirchstrasse 14**
**D-1000 Berlin 15(DE)**
Erfinder: **Vach, Wilhelm, Dr.**
**Auenstrasse 14 a**
**D-8055 Hallbergmoos(DE)**
Erfinder: **Krenner, Johann**
**Erdinger Strasse 18**
**D-8059 Berglern(DE)**

(74) Vertreter: **Mehl, Ernst, Dipl.-Ing. et al**
**Postfach 22 01 76**
**D-8000 München 22(DE)**

(54) **Anordnung zur Belichtung von Halbleiterscheiben mittels Synchrotronstrahlung in einem Lithographiegerät.**

(57) Anordnung zur Belichtung von Halbleiterscheiben mittels Synchrotronstrahlung, bei der eine Maske (2) und eine Halbleiterscheibe (1) gemeinsam senkrecht zur Richtung des belichtenden Röntgenstrahls (5) bewegbar sind, um ein Belichtungsfeld (BF) zu überstreichen. Dabei sind optische Einrichtungen (27, 28) vorgesehen, über die Justiermarken auf Maske (2) und Halbleiterscheibe (1) aus-gewertet und Stellsignale zur gegenseitigen Justierung dieser Teile abgeleitet werden. Es wird vorgeschlagen, ein schlitzförmiges Strahlungsfenster (4c) unmittelbar vor der Maske (2) anzuordnen und die optischen Einrichtungen (27, 28) neben der Strahlzuführung (4b) vorzusehen und auf einen während der Justierung außerhalb der Auftrefffläche des Röntgenstrahls (5) liegenden Teil des Belichtungsfel-

des (BF) auszurichten.

**FIG 1**

# Anordnung zur Belichtung von Halbleiterscheiben mittels Synchrotron-Strahlung in einem Lithographiegerät

Die Erfindung bezieht sich auf eine Anordnung zur Belichtung von Halbleiterscheiben mittels Synchrotron-Strahlung in einem Lithographiegerät nach dem Oberbegriff des Anspruchs 1.

Eine Anordnung dieser Art ist dem Aufsatz "Overlay Measurements for X-Ray-Lithographie" von K. H. Müller und H. Burghausen, veröffentlicht im J. Vac. Sci. Technol. B3 (1) Jan./Febr. 1985, Seiten 241-244, zu entnehmen. Hierbei ist das Strahlungsfenster in die Wandung einer Belichtungskammer eingefügt, in der entweder ein Vakuum oder eine He-Atmosphäre von etwa 50 mbar aufgebaut werden, um den Röntgenstrahl möglichst verlustfrei an die in der Belichtungskammer angeordnete Masken-Halbleiter-Kombination heranzuführen. Die Beobachtung der auf der Maske und der Halbleiterscheibe angebrachten Justiermarken erfolgt über ein Mikroskop mit zwei Objektiven, die in der Belichtungskammer um eine ortsfeste Achse schwenkbar angeordnet sind.

Zum Zwecke der gegenseitigen Justierung von Maske und Halbleiterscheibe werden die Objektive hierbei in eine Arbeitslage zwischen dem Strahlungsfenster und der Maske eingeschwenkt, in der sie sich in Strahlrichtung unmittelbar vor der Maske befinden und auf die Justiermarken ausgerichtet sind. Nach der Justierung werden sie aus der Arbeitslage herausgeschwenkt, so daß der Röntgenstrahl ungehinderten Zutritt finden kann. Anschließend erfolgt die Belichtung der Masken-Halbleiterscheiben-Kombination, wobei die letztere im justierten Zustand senkrecht zur Strahlrichtung durch den Strahl hindurchbewegt wird, um ein Belichtungsfeld zu überstreichen, das größer ist als die durch das Strahlungsfenster bestimmte Auftrefffläche des Röntgenstrahls. Bei dieser Anordnung ist es erforderlich, die Belichtungskammer beim Austausch einer belichteten Halbleiterscheibe gegen eine zu belichtende oder beim Austausch der verwendeten Maske gegen eine andere zu öffnen und dann zur Fortsetzung des Belichtungsvorgangs das Vakuum oder die He-Atmosphäre wieder aufzubauen, was den Belichtungsvorgang langwierig und umständlich macht. Weiterhin müssen für jeden Justiervorgang die Objektive des Mikroskops in die Arbeitslage eingeschwenkt und vor Beginn der sich anschließenden Belichtung wieder ausgeschwenkt werden, was den Bedienungsaufwand weiter vergrößert.

Der Erfindung liegt die Aufgabe zugrunde, eine Anordnung der eingangs genannten Art anzugeben, bei der diese Nachteile nicht auftreten. Das wird erfindungsgemäß durch eine Ausbildung nach dem kennzeichnenden Teil des Anspruchs 1 erreicht.

Die erfindungsgemäße Anordnung zeichnet sich insbesondere dadurch aus, daß mit ihr eine schnellere Belichtung einer Halbleiterscheibe erfolgen kann, als das mit einer vergleichbaren herkömmlichen Anordnung der Fall wäre, weil die zu evakuierende oder mit einer He-Atmosphäre zu beaufschlagende Belichtungskammer entfällt. Dieser Vorteil gilt verstärkt für die Belichtung einer Halbleiterscheibe, die eine Mehrzahl von Belichtungsfeldern aufweist, sowie für die Belichtung einer Reihe von Halbleiterscheiben, die jeweils mit derselben Maske zu strukturieren sind.

Die Ansprüche 2 bis 6 sind auf bevorzugte Ausgestaltungen und Weiterbildungen der Erfindung gerichtet.

Die Erfindung wird nachfolgend anhand eines in der Zeichnung dargestellten, bevorzugten Ausführungsbeispiels näher erläutert. Dabei zeigt:

Fig. 1 eine schematische Schnittdarstellung einer nach der Erfindung ausgebildeten Anordnung, und

Fig. 2 eine Ansicht der Anordnung nach Figur 1.

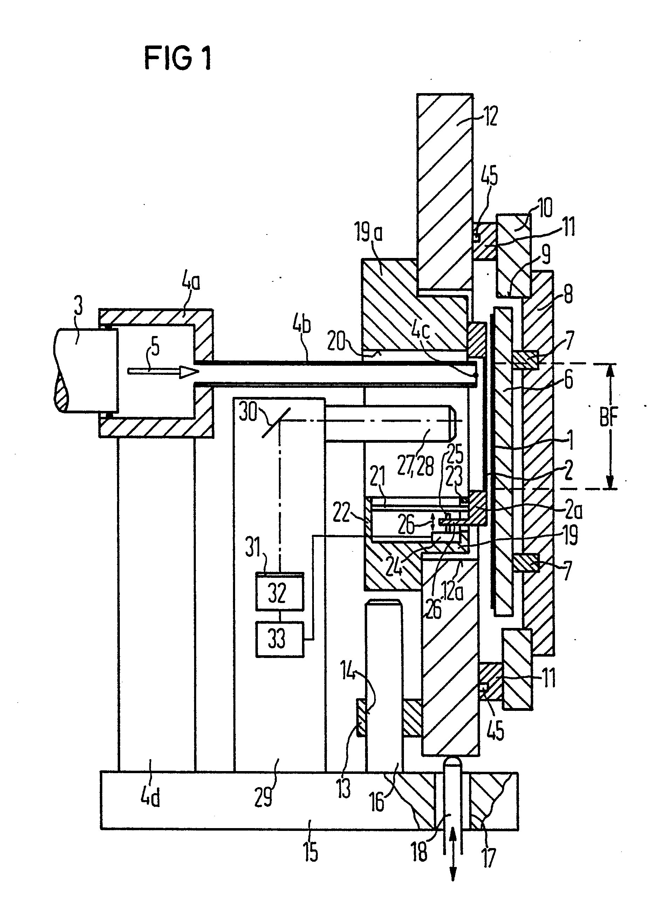

Fig. 1 zeigt ein Lithographiegerät mit einer Anordnung zur Belichtung einer zu strukturierenden Halbleiterscheibe 1 unter Verwendung einer in einem vorgegebenen Abstand zu ihr gehaltenen strukturierten Maske 2 mittels einer über ein Rohr 3 zugeführten Synchrotronstrahlung. Dabei handelt es sich um eine Röntgenstrahlung hoher Parallelität, die zweckmäßigerweise aus dem Speicherring eines Elektronenbeschleunigers ausgekoppelt wird. An das Rohr 3 schließt sich eine Strahlzuführung 4 an, die aus einem auf einer Säule 4d befestigten zylindrischen Teil 4a und einem Ansatz 4b mit rechteckigem Querschnitt besteht, der durch ein Strahlungsfenster 4c abgeschlossen ist. Die in den Teilen 3 bis 4b geführte Röntgenstrahlung wird durch den die Strahlrichtung angebenden Pfeil 5 angedeutet. Die senkrecht zur Bildebene gemessene lichte Breite der Teile 4b und 4c ist dabei größer bemessen als ihre in vertikaler Richtung gemessene lichte Höhe, so daß der Querschnitt von 4b und 4c dem bandförmigen Querschnitt des über 3 zugeführten Röntgenstrahlenbündels angepaßt ist. Die lichte Breite kann z.B. 40 mm betragen, die lichte Höhe etwa 8 mm.

Die Halbleiterscheibe 1 ist auf einer Halteplatte 6 befestigt, die ihrerseits durch Verbindungselemente 7 an einer Einlegeplatte 8 angebracht ist. Diese wird in die Ausnehmung 9 eines Tisches 10 eingelegt und mit diesem fest verbunden. Der Tisch 10 ist seinerseits mit Abstandselementen 11 versehen, die ihn in einem vorgegebenen Abstand zu einer Tafelplatte 12 halten. Letztere befindet sich in einer zur Strahlrichtung 5 senkrechten Ebene und ist in dieser Ebene in vertikaler Richtung verschiebbar. Zu diesem Zweck ist ein Ansatz 13 der Tafelplatte mit einer Bohrung 14 versehen, die auf einem an einer Bodenplatte 15 befestigten Bolzen 16 verschiebbar gelagert ist. Ein Stift 18, der durch eine Öffnung 17 der Bodenplatte ragt und durch eine nicht dargestellte Antriebseinrichtung in Längsrichtung bewegbar ist, verschiebt die Tafelplatte und damit auch die über die Teile 6 bis 11 mit ihr verbundene Halbleiterscheibe 1 senkrecht zur Strahlrichtung 5.

Die Maske 2, die eine verstärkte Randzone 2a aufweist, ist auf einer Maskenhalterung 19 angebracht. Diese hat eine Ausnehmung 20, die von der Maske 2 überdeckt wird. Die Maskenhalterung 19 ist dabei mittels eines flanschartigen Teils 19a an der in Strahlrichtung vorderen Seite der Tafelplatte 12 befestigt und ragt in eine Ausnehmung 12a der Tafelplatte 12. Damit befindet sich auch die Maske 2 innerhalb der Ausnehmung 12a bzw. in einer Lage, die hierzu in Strahlrichtung 5 versetzt ist. Ein Versatz entgegen der Strahlrichtung 5 wäre jedoch ebenso möglich. Die Maskenhalterung 19 ist weiterhin so ausgebildet, daß die Maske 2 in einer senkrecht zur Strahlrichtung 5 liegenden Ebene in zwei Richtungen parallel verschiebbar und zusätzlich drehbar gelagert ist. Im einzelnen ist die Maske 2 mittels dreier Stifte, von denen einer in Figur 1 dargestellt und mit 21 bezeichnet ist, mit einem die Ausnehmung 20 teilweise abdeckenden Bodenteil 22 verbunden, wobei die Stifte durch Ausnehmungen, zum Beispiel 23, der Maskenhalterung 19 hindurch ragen. Die genannte Relativbewegung zwischen der Maske 2 und der Maskenhalterung 19 wird mittels dreier insbesondere piezoelektrischer Stelleinrichtungen, z. B. 24, bewirkt, deren Stellstifte, z. B. 25, auf Ansätze 2b in einer der Richtungen des Doppelpfeils 26 einwirken. Durch drei Stelleinrichtungen 24, die auf zwei Ansätze 2b einwirken, können die genannten Relativbewegungen zwischen den Teilen 2 und 19 erzeugt werden. Eine in dieser Art aufgebaute Maskenhalterung ist an sich bereits bekannt, zum Beispiel aus dem IBM Techn. Discl. Bull., Vol. 25, No. 12, Mai 1983, Seiten 6400 bis 6401.

Die gegenseitige Justierung der Halbleiterscheibe 1 und der Maske 2 erfolgt mit Hilfe von wenigstens zwei optischen Einrichtungen, zum Beispiel 27 und 28, die in Figur 1 hintereinanderliegen, so daß nur eine von ihnen, z. B. 27, sichtbar ist. Unter diesen Einrichtungen sind insbesondere zwei Objektive eines Mikroskops zu verstehen, das vorzugsweise in einer Säule 29 angeordnet ist und die Bilder der Justiermarken über Spiegel 30 auf den Bildschirm 31 einer Fernsehaufnahmeeinrichtung 32 überträgt, welche hiervon elektrische Signale ableitet, die einer elektronischen Datenverarbeitung 33 zugeführt werden. Diese leitet aus den erhaltenen elektrischen Signalen Stellsignale ab, die den Stelleinrichtungen 24 zugeführt werden. Mit Hilfe dieser Stellsignale erfolgt eine Feinjustierung der Lage der Maske 2 in bezug auf die hierbei ortsfest zu denkende Halbleiterscheibe 1, so daß eine genaue Lageabstimmung dieser beiden Teile erreicht wird.

Das Strahlungsfenster 4c befindet sich in Strahlrichtung 5 unmittelbar vor der Maske 2, wobei es innerhalb der Ausnehmung 20 bzw. entsprechend Figur 1 innerhalb der rahmenartigen verstärkten Randzone 2a der Maske 2 ortsfest angeordnet ist. Die optischen Einrichtungen 27, 28 sind dabei neben der Strahlzuführung 4b vorgesehen und liegen ebenfalls im Inneren der Ausnehmung 20. Wenn man den dem Strahlungsfenster 4c gegenüberliegenden Teil der Maske bzw. der Halbleiterscheibe als Auftrefffläche bezeichnet, so sind die optischen Einrichtungen 27, 28 auf solche Teile der Maske 2 ausgerichtet, die in der in Figur 1 dargestellten relativen Lage der Teile 1, 2 und 4 außerhalb der Auftrefffläche der zugeführten Synchrotronstrahlung liegen.

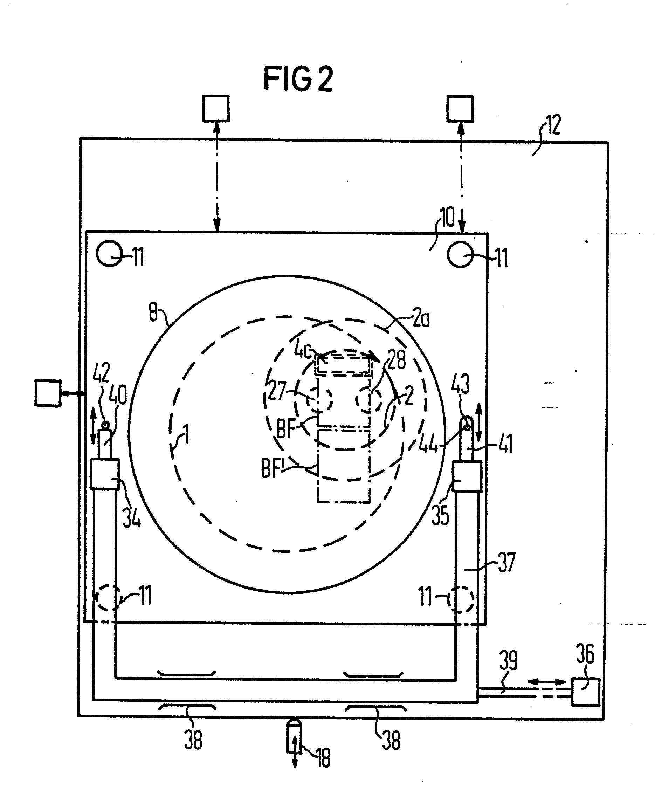

Zur Belichtung der Halbleiterscheibe 1 wird nun so vorgegangen, daß 1 zunächst gegenüber der Tafelplatte 12 und damit gegenüber der an dieser gehaltenen Maske 2 in eine solche Lage gebracht wird, daß ein bestimmtes Belichtungsfeld BF der Maske gegenüberliegt. Das geschieht in der weiter unten anhand der Fig. 2 beschriebenen Weise. Damit befinden sich die Justiermarken der Halbleiterscheibe und der Maske 2 so dicht nebeneinander, daß ihre Bilder über die optischen Einrichtungen 27, 28 aufgenommen und auf den Bildschirm 31 übertragen werden können. Die in der Einrichtung 33 abgeleiteten Stellsignale beeinflussen die Stelleinrichtungen 24 dann so, daß eine genaue gegenseitige Justierung der Teile 1 und 2 gewährleistet ist.

In der justierten Lage werden nun die Tafelplatte 12 und mit ihr die Halbleiterscheibe 1 und die Maske 2 durch eine nach oben gerichtete Bewegung des Stellstiftes 18 senkrecht nach oben bewegt, so daß bei Zuführung eines parallelen Röntgenstrahls 5 die Auftrefffläche allmählich von oben nach unten über das gesamte Belichtungsfeld BF verschoben wird. Diese gemeinsame Bewegung der Teile 1 und 2 am Strahlungsfenster 4c vorbei kann auch als "Scan"-Bewegung bezeichnet werden. Nach der Belichtung des Belichtungsfeldes BF wird dann die Halbleiterscheibe 1 gegenüber der Tafelplatte 12 und damit gegenüber der Maske 2 so verstellt, daß der Maske ein neues Belichtungsfeld BF' gegenüberliegt. Diese Einstellung kann als eine "Step"-Bewegung aufgefaßt werden.

Fig. 2 zeigt eine Ansicht der Anordnung nach Figur 1 entgegen der Strahlrichtung 5. Wie hieraus hervorgeht, ist der Tisch 10, in dessen Ausnehmung die Einlegeplatte 8 mit der Halbleiterscheibe eingepaßt ist, mittels Antriebsvorrichtungen 34, 35 und 36 relativ zur Tafelplatte 12 bewegbar. Mit Vorteil wird der Tisch 10 zwischen der Tafelplatte 12 und einer U-förmigen Kulisse 37 gehalten, die in einer an der Tafelplatte 12 angebrachten Führung 38 horizontal verschiebbar gelagert ist. Der Antrieb der Kulisse 37 in dieser Richtung erfolgt über den Stellstift 39 der ebenfalls an 12 befestigten Antriebsvorrichtung 36. Die Stellstifte 40 und 41 der an der Kulisse 37 befestigten Antriebsvorrichtungen 34 und 35 verschieben den Tisch 10 mittels der an ihm befestigten Stifte 42 und 43, von denen der letztere in einer Bohrung 44 des Stellstiftes 41 gehalten wird. Die Stellstifte 39, 40 und 41 sind jeweils in beiden Richtung der eingezeichneten Doppelpfeile bewegbar. Durch die Vorrichtungen 34 bis 36 werden die erwähnten "Step"-Bewegungen erzeugt, durch die die Halbleiterscheibe 1 gegenüber der Maske 2 auf verschiedene Belichtungsfelder BF bzw. BF' eingestellt wird. Mit 27 und 28 sind wieder die beiden optischen Einrichtungen bezeichnet, die zur Feinjustierung von Maske und Halbleiterscheibe dienen.

Die zweckmäßigerweise am Tisch 10 befestigten Abstandselemente 11 sind vorzugsweise mit vakuumgesteuerten Saugvorrichtungen versehen, die in Fig. 1 durch Rillen 45 angedeutet sind. Durch den Aufbau eines Vakuums in den Rillen 45 werden dabei die Tafelplatte 12 und der Tisch 10 miteinander verklammert. Das geschieht nach der Einstellung der Halbleiterscheibe 1 auf ein bestimmtes, der Maske 2 gegenüberliegendes Belichtungsfeld, z.B. BF, mittels der Vorrichtungen 34 bis 36 und vor der gegenseitigen Justierung der Teile 1 und 2 mittels der Stelleinrichtungen 24.

| Bezugszeichenliste | 1 | Halbleiterscheibe |
|---|---|---|
| 2 | Maske | |
| 2a | Randzone von 2 | |
| 2b | Ansätze von 2a | |
| 3 | Rohr | |
| 4a | zylindrischer Teil der Strahlzuführung | |
| 4b | Ansatz | |
| 4c | Strahlungsfenster | |
| 4d | Säule | |
| 5 | Strahlrichtung | |
| 6 | Halteplatte | |
| 7 | Verbindungselemente | |
| 8 | Einlegeplatte | |
| 9 | Ausnehmung | |
| 10 | Tisch | |
| 11 | Abstandselemente | |
| 12 | Tafelplatte | |
| 12a | Ausnehmung von 12 | |
| 13 | Ansatz von 12 | |
| 14 | Bohrung | |
| 15 | Bodenplatte | |
| 16 | Bolzen | |
| 17 | Öffnung von 15 | |
| 18 | Stift | |
| 19 | Maskenhalterung | |
| 19a | flanschartiger Teil von 19 | |
| 20 | Ausnehmung von 19 | |
| 21 | Stift | |
| 22 | Bodenteil von 19 | |
| 23 | Ausnehmungen von 19 | |
| 24 | Stelleinrichtungen | |
| 25 | Stellstifte | |
| 26 | Pfeil | |
| 27, 28 | optische Einrichtungen | |
| 29 | Säule | |
| 30 | Spiegel | |
| 31 | Bildschirm | |
| 32 | Fernsehaufnahmevorrichtung | |
| 33 | elektronische Datenverarbeitung | |
| 34, 35, 36 | Antriebsvorrichtungen | |
| 37 | Kulisse | |
| 38 | Führung | |
| 39, 40, 41 | Stellstifte | |
| 42, 43 | Stifte | |
| 44 | Bohrung von 41 | |
| 45 | Rillen | |

## Ansprüche

1. Anordnung zur Belichtung von Halbleiterscheiben mittels Synchrotronstrahlung in einem Lithographiegerät,

-bei der ein in einer Strahlzuführung (4a, 4b) geführter, paralleler Röntgenstrahl aus einem Strahlungsfenster (4c) austritt und auf eine strukturierte Maske (2) und eine im Abstand dahinterliegende, zu strukturierende Halbleiterscheibe (1) auftrifft,

-bei der die Maske (2) und die Halbleiterscheibe (1) gemeinsam senkrecht zur Strahlrichtung (5) bewegbar sind, um ein Belichtungsfeld (BF) zu überstreichen, das größer ist als die durch das Strahlungsfenster (4c) bestimmte Auftrefffläche des Röntgenstrahls, und

-bei der auf der Maske (2) und der Halbleiterscheibe (1) vorgesehene Justiermarken über optische Einrichtungen (27, 28) ausgewertet und zur Ableitung von Stellsignalen verwendet werden, die eine Vorrichtung (24) zur gegenseitigen Justierung von Maske und Halbleiterscheibe steuern,

**dadurch gekennzeichnet,**

-daß das Strahlungsfenster (4c) schlitzförmig ausgebildet und unmittelbar vor der Maske (2) ortsfest angeordnet ist und

-daß die optischen Einrichtungen (27, 28) neben der Strahlzuführung vorgesehen und auf einen während der Justierung außerhalb der Auftrefffläche liegenden Teil der Maske (2) ausgerichtet sind.

2. Anordnung nach Anspruch 1, **dadurch gekennzeichnet,** daß die Maske (2) und die Halbleiterscheibe·(1) auf einer Tafelplatte (12) gehalten werden, mit der sie gemeinsam senkrecht zur Strahlrichtung (5) bewegbar sind, und daß die Maske (2) in einer Ausnehmung (12a) der Tafelplatte oder hierzu in oder entgegen der Strahlrichtung (5) versetzt angeordnet ist.

3. Anordnung nach Anspruch 1 oder 2, **dadurch gekennzeichnet,** daß die optischen Einrichtungen (27, 28) teilweise innerhalb der Ausnehmung der Tafelplatte (12) ortsfest angeordnet sind.

4. Anordnung nach einem der Ansprüche 1 bis 3, **dadurch gekennzeichnet,** daß eine Halterung (8, 10) für die Halbleiterscheibe (1) vorgesehen ist, die eine Bewegung der letzteren relativ zur Maske (2) und senkrecht zur Strahlrichtung (5) zuläßt, um eine sequentielle Bestrahlung einer Mehrzahl von Belichtungsfeldern (BF, BF') zu erzielen.

5. Anordnung nach Anspruch 4, **dadurch gekennzeichnet,** daß sich die Halterung (8, 10) für die Halbleiterscheibe auf der in Strahlrichtung (5) hinteren Seite der Tafelplatte (12) befindet.

6. Anordnung nach einem der Ansprüche 1 bis 5, **dadurch gekennzeichnet,** daß eine Maskenhalterung (19) vorgesehen ist, die auf der in Strahlrichtung vorderen Seite der Tafelplatte (12) angebracht ist.

FIG 1

## FIG 2